# EUROPEAN PATENT APPLICATION

(11) **EP 4 701 375 A1**
(43) Date of publication of application: **25.02.2026**
(21) Application number: 25766860.8
(22) Date of filing: 01.07.2025
(51) Int. Cl.: H10F 77/30

(54) **CELL STRING AND PHOTOVOLTAIC MODULE**

(30) Priority: 11.07.2024 CN 202410924414
(71) Applicant: Longi Green Energy Technology Co., Ltd., Xi'an, Shaanxi 710100 (CN)
(72) Inventor: CHEN, Jun, Xi'an, Shaanxi 710100 (CN); ZHANG, Huang, Xi'an, Shaanxi 710100 (CN); YANG, Dongsheng, Xi'an, Shaanxi 710100 (CN); CHEN, Weiqiang, Xi'an, Shaanxi 710100 (CN); CHANG, Qian, Xi'an, Shaanxi 710100 (CN)
(74) Representative: Grünecker Patent- und Rechtsanwälte PartG mbB
(86) International application number: PCT/CN2025/106508
(87) International publication number: WO 2026/012253

(57) **Abstract**

The present application discloses a solar cell string and a photovoltaic module, belonging to the field of photovoltaic technologies. The solar cell string includes a solar cell and first connecting members. The solar cell includes a substrate and a plurality of first doped layers and a plurality of second doped layers formed on a first surface of the substrate. The first doped layers and the second doped layers all extend along a first direction and are alternately arranged along a second direction. A first isolation region is provided between the first doped layer and the adjacent second doped layer. First fingers are disposed on the first doped layers. Second fingers are disposed on the second doped layers. The first fingers and the second fingers all extend along the first direction. The second direction intersects with the first direction. The first connecting members extend along the second direction. The first connecting members are connected to the first fingers. In a first region of the first surface, intersections of the first connecting members and the second fingers are provided with a plurality of second insulating blocks in a one-to-one correspondence with the second fingers. Along the second direction, at least a part of the second insulating blocks extends into the first isolation regions adjacent thereto.

## Description

The present application claims priority to Chinese Patent Application No. 202410924414.7, filed with the China National Intellectual Property Administration on July 11, 2024 and entitled "SOLAR CELL STRING AND PHOTOVOLTAIC MODULE", which is incorporated herein by reference in its entirety.

### TECHNICAL FIELD

The present application relates to the field of photovoltaic technologies, and in particular to a solar cell string and a photovoltaic module.

### BACKGROUND

A solar cell, serving as a core component of a photovoltaic module, can convert solar energy into electric energy. In a back contact solar cell, positive electrode grid lines and negative electrode grid lines of the solar cell are all disposed on a back of the solar cell, so that the positive electrode grid lines and the negative electrode grid lines do not block a front of the solar cell, thereby improving a photoelectric conversion efficiency of the solar cell. In a busbar-free back contact solar cell, only positive electrode fingers and negative electrode fingers, but no busbars are disposed on the back of the solar cell, and a soldering strip is connected to the positive electrode fingers or the negative electrode fingers to gather current collected by the positive electrode fingers or the negative electrode fingers and transfer the current to an external circuit.

In the related art, the positive electrode fingers and the negative electrode fingers of the busbar-free back contact solar cell all extend along a first direction, and are alternately arranged along a second direction. That is, along the second direction, two sides of one positive electrode finger are respectively provided with one negative electrode finger. In an example in which the soldering strip is connected to the positive electrode fingers, a bonding layer is disposed at a joint between the positive electrode fingers and the soldering strip, so that a reliability of connection between the soldering strip and the positive electrode fingers is improved by using the bonding layer. An insulating layer is disposed between the negative electrode fingers and the soldering strip, so that the soldering strip and the negative electrode fingers are blocked by using the insulating layer, so as to avoid a short-circuit in the solar cell.

However, with the foregoing disposition, a material of the bonding layer easily overflows into a gap between the positive electrode finger and the adjacent negative electrode finger, causing electric leakage in the photovoltaic module.

### SUMMARY

The present application provides a solar cell string and a photovoltaic module, to resolve or at least partially resolve the problem in the related art that a material of a bonding layer easily overflows into a gap between a positive electrode finger and an adjacent negative electrode finger, causing electric leakage in the photovoltaic module.

In a first aspect, the present application discloses a solar cell string. The solar cell string includes a solar cell and first connecting members. The solar cell includes a substrate and a plurality of first doped layers and a plurality of second doped layers formed on a first surface of the substrate. The first doped layers and the second doped layers all extend along a first direction and are alternately arranged along a second direction. A first isolation region is provided between the first doped layer and the adjacent second doped layer. First fingers are disposed on the first doped layers. Second fingers are disposed on the second doped layers. The first fingers and the second fingers all extend along the first direction. The second direction intersects with the first direction. The first connecting members extend along the second direction. The first connecting members are connected to the first fingers. In a first region of the first surface, intersections of the first connecting members and the second fingers are provided with a plurality of second insulating blocks in a one-to-one correspondence with the second fingers. Along the second direction, at a least part of the second insulating blocks extend into the first isolation regions adjacent thereto.

In a second aspect, the present application further discloses a photovoltaic module, including the solar cell string according to the first aspect.

The present application discloses a solar cell string and a photovoltaic module. The solar cell string includes a solar cell and first connecting members. The solar cell includes a substrate and a plurality of first doped layers and a plurality of second doped layers formed on a first surface of the substrate. The first doped layers and the second doped layers all extend along a first direction and are alternately arranged along a second direction. A first isolation region is provided between the first doped layer and the adjacent second doped layer. First fingers are disposed on the first doped layers. Second fingers are disposed on the second doped layers. The first fingers and the second fingers all extend along the first direction. The second direction intersects with the first direction. The first connecting members extend along the second direction. The first connecting members are connected to the first fingers. In a first region of the first surface, intersections of the first connecting members and the second fingers are provided with a plurality of second insulating blocks in a one-to-one correspondence with the second fingers. Along the second direction, at least a part of the second insulating blocks extends into the first isolation regions adjacent thereto.

In the present application, the first connecting members are connected to the first fingers. The first connecting members gather current collected by the first fingers and transfer the current to an external circuit. In the first region of the first surface, the intersections of the first connecting members and the second fingers are provided with the plurality of second insulating blocks in a one-to-one correspondence with the second fingers. The second insulating blocks block the first connecting members from the second fingers, to avoid a short-circuit in the solar cell string, thereby improving a reliability of the solar cell string.

Further, in the present application, along the second direction, the at least a part of the second insulating blocks extends into the first isolation regions adjacent thereto. With the above disposition, after the second insulating blocks are solidified, a reliability of a connection between the first connecting members and the first fingers is not affected, so as to avoid pseudo soldering in the solar cell string, thereby helping improve a photoelectric conversion efficiency of the solar cell string.

In addition, the second insulating block can fill up the first isolation region below the first connecting member. This can prevent a bonding material from overflowing to the first isolation regions and from being connected to the second fingers during soldering between the first connecting member and the first finger, causing a short-circuit in the solar cell string, thereby helping improve the reliability of the solar cell string.

The foregoing descriptions are merely an overview of the technical solutions in the present application. In order that technical means of the present application can be understood more clearly so that the technical solutions can be implemented according to content of this specification, and in order that the foregoing and other objectives, features, and advantages of the present application can be understood more clearly, specific implementations of the present application are described below.

### BRIEF DESCRIPTION OF THE DRAWINGS

To describe the technical solutions in embodiments of the present application more clearly, the following briefly describes the accompanying drawings required in the embodiments. Apparently, the accompanying drawings in the following description show merely some embodiments of the present application, and a person of ordinary skill in the art can still derive other accompanying drawings from these accompanying drawings without creative efforts.
FIG. 1 is a top view of a solar cell string according to an embodiment of the present application;
FIG. 2 is a schematic partial structural view of the solar cell string according to an embodiment of the present application;
FIG. 3 is an enlarged view of the solar cell string at region A1 in FIG. 1;
FIG. 4 is a sectional view of the solar cell string taken along line C1-C2 in FIG. 3;
FIG. 5 is an enlarged view I of the solar cell string at region B1 in FIG. 1;
FIG. 6 is a sectional view of the solar cell string taken along line D1-D2 in FIG. 5;
FIG. 7 is an enlarged view II of the solar cell string at region B1 in FIG. 1;
FIG. 8 is a sectional view of the solar cell string taken along line E1-E2 in FIG. 7;
FIG. 9 is an enlarged view I of the solar cell string at region A2 in FIG. 1;
FIG. 10 is an enlarged view I of the solar cell string at region B2 in FIG. 1;
FIG. 11 is an enlarged view II of the solar cell string at region A2 in FIG. 1; and
FIG. 12 is an enlarged view II of the solar cell string at region B2 in FIG. 1.

### Reference signs:

10: solar cell; 11: substrate; 12: first doped layer; 13: second doped layer; 14: first region; 15: second region;
20: first finger; 21: thickened section; 22: second finger;
30: first isolation region; 31: second isolation region;
40: first bonding block;
50: first connecting member; 51: second connecting member;
60: first insulating block; 61: second insulating block;
70: first connecting portion; 71: end line;
X: first direction; and Y: second direction.

### DETAILED DESCRIPTION

To make the objectives, technical solutions, and advantages of embodiments of the present application clearer, the following clearly and completely describes the technical solutions in the embodiments of the present application with reference to the accompanying drawings in the embodiments of the present application. Apparently, the described embodiments are some of the embodiments of the present application rather than all the embodiments. All other embodiments obtained by a person of ordinary skill in the art based on the embodiments of the present application without creative efforts shall fall within the protection scope of the present application.

A solar cell string provided in an embodiment of the present application is described below through specific embodiments and application scenarios thereof with reference to the accompanying drawings.

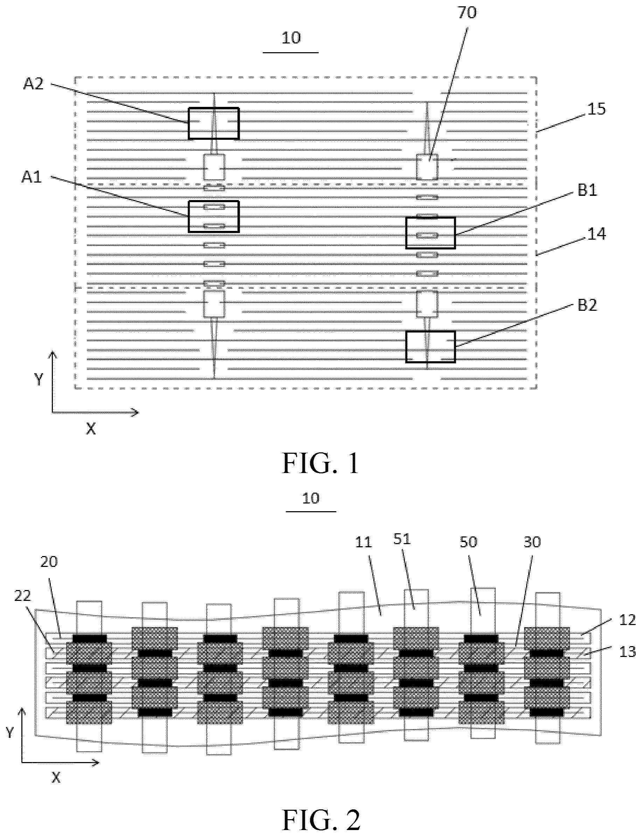

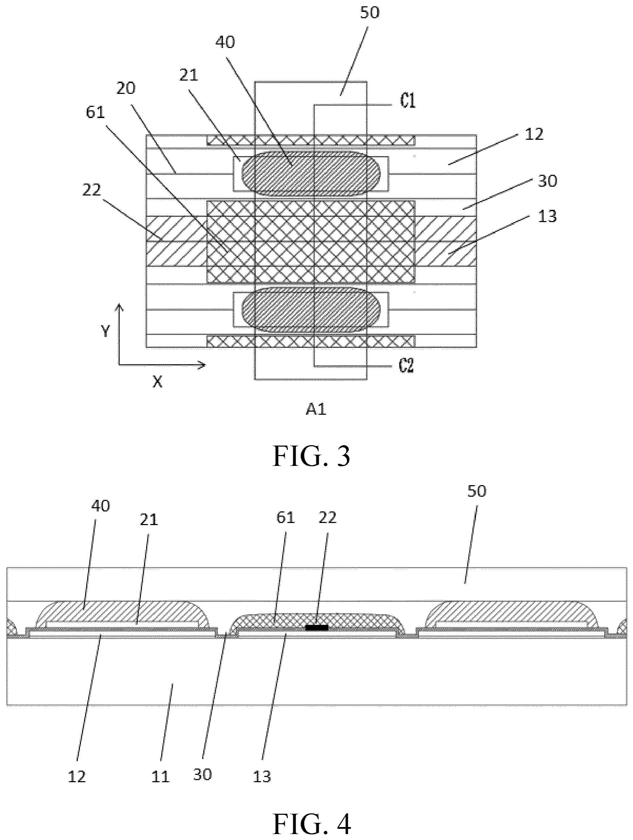

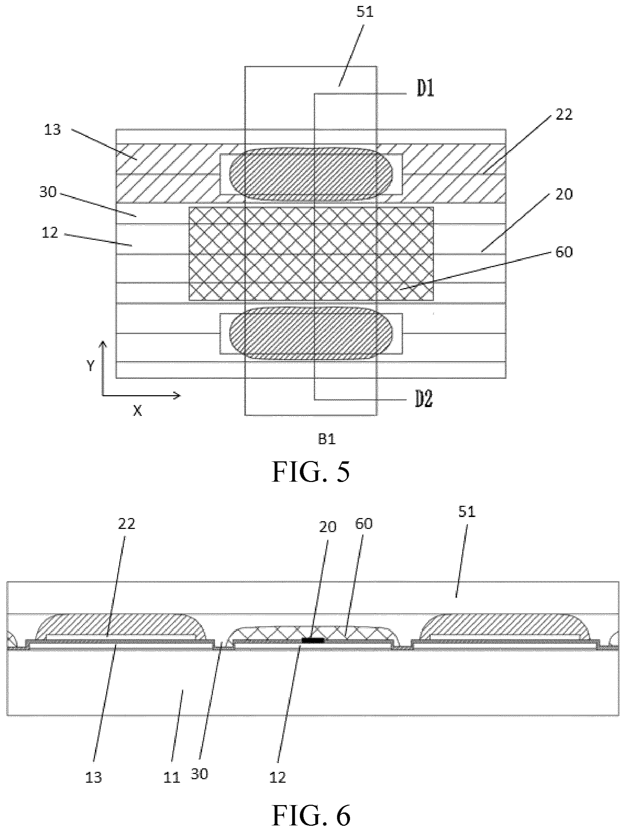

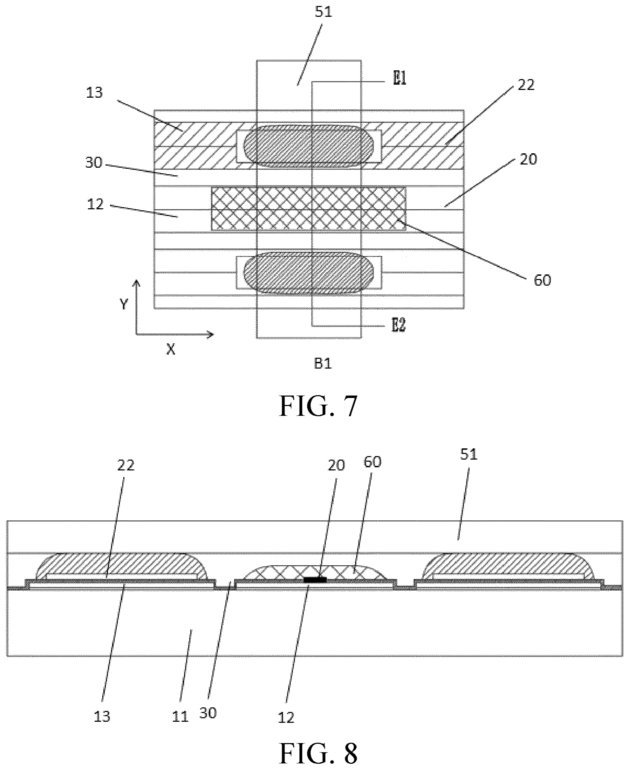

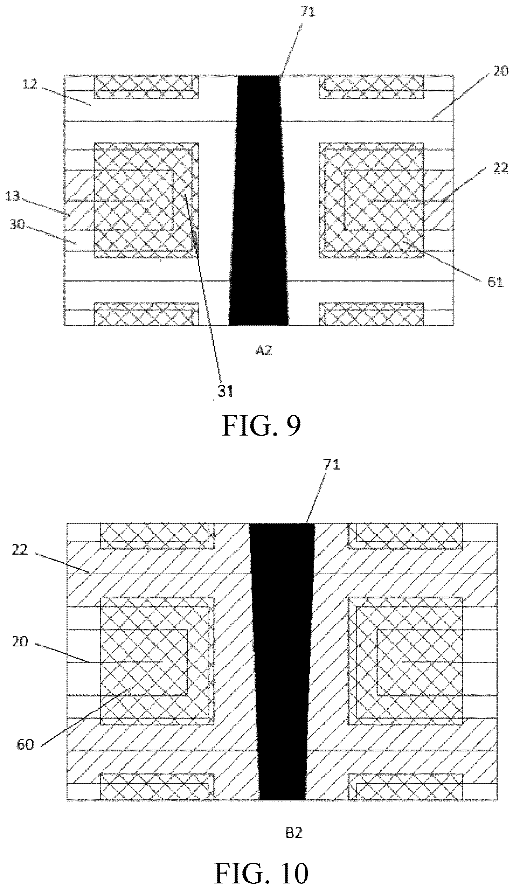

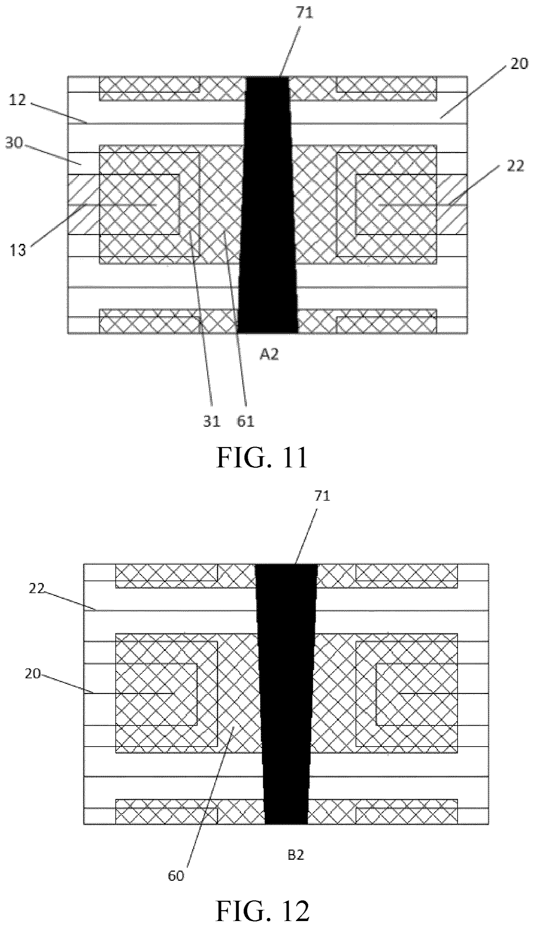

FIG. 1 is a top view of a solar cell string according to an embodiment of the present application. FIG. 2 is a schematic partial structural view of the solar cell string according to an embodiment of the present application. FIG. 3 is an enlarged view of the solar cell string at region A1 in FIG. 1. FIG. 4 is a sectional view of the solar cell string taken along line C1-C2 in FIG. 3. FIG. 5 is an enlarged view I of the solar cell string at region B1 in FIG. 1. FIG. 6 is a sectional view of the solar cell string taken along line D1-D2 in FIG. 5. FIG. 7 is an enlarged view II of the solar cell string at region B1 in FIG. 1. FIG. 8 is a sectional view of the solar cell string taken along line E1-E2 in FIG. 7. FIG. 9 is an enlarged view I of the solar cell string at region A2 in FIG. 1. FIG. 10 is an enlarged view I of the solar cell string at region B2 in FIG. 1. FIG. 11 is an enlarged view II of the solar cell string at region A2 in FIG. 1. FIG. 12 is an enlarged view II of the solar cell string at region B2 in FIG. 1.

As shown in FIG. 1 to FIG. 12, an embodiment of the present application discloses a solar cell string. The solar cell string includes a solar cell 10 and first connecting members 50. The solar cell 10 includes a substrate 11 and a plurality of first doped layers 12 and a plurality of second doped layers 13 formed on a first surface of the substrate 11. The first doped layers 12 and the second doped layers 13 all extend along a first direction X and are alternately arranged along a second direction Y. A first isolation region 30 is provided between the first doped layer 12 and the adjacent second doped layer 13. First fingers 20 are disposed on the first doped layers 12. Second fingers 22 are disposed on the second doped layers 13. The first fingers 20 and the second fingers 22 all extend along the first direction X. The second direction Y intersects with the first direction X. The first connecting members 50 extend along the second direction Y. The first connecting members 50 are connected to the first fingers 20. In a first region 14 of the first surface, intersections of the first connecting members 50 and the second fingers 22 are provided with a plurality of second insulating blocks 61 in a one-to-one correspondence with the second fingers 22. Along the second direction Y, at least a part of the second insulating blocks 61 extend into the first isolation regions 30 adjacent thereto.

The solar cell string disclosed in this embodiment of the present application includes the solar cell 10. The solar cell 10 includes the substrate 11. The substrate 11, serving as a core component of the solar cell 10, can convert solar energy into electric energy. In addition, the solar cell 10 in this embodiment of the present application is a busbar-free solar cell, and the busbar-free solar cell has only the first connecting portions 70 at end portions or harpoon structures (not shown in the figure). The substrate 11 has a first surface and a second surface that are opposite to each other. The first surface is a backlight surface facing away from sunlight, which is also referred to as a back. The second surface is a light receiving surface facing the sunlight, which is also referred to as a front.

As shown in FIG. 1 to FIG. 12, the first surface of the substrate 11 has the plurality of first doped layers 12 and the plurality of second doped layers 13. It can be understood that the plurality of first doped layers 12 and the plurality of second doped layers 13 are all disposed on the back of the substrate 11, that is, the solar cell disclosed in the present application is a back contact solar cell. The first doped layers 12 and the second doped layers 13 all extend along the first direction X and are alternately arranged along the second direction Y. The first doped layers 12 and the second doped layers 13 collect current generated by the substrate 11.

Along the second direction Y, the first isolation region 30 is provided between the first doped layer 12 and the adjacent second doped layer 13. The first isolation region 30 blocks the first doped layer 12 and the second doped layer 13, so as to prevent the first doped layer 12 and the second doped layer 13 from electrical conduction, causing a short-circuit in the solar cell and thus affecting a photoelectric conversion efficiency of the solar cell.

As shown in FIG. 1 to FIG. 12, the first fingers 20 are disposed on the first doped layers 12. The second fingers 22 are disposed on the second doped layers 13. The first fingers 20 and the second fingers 22 all extend along the first direction X. It can be understood that the first fingers 20 are disposed on the first doped layers 12, and an extending direction of the first fingers 20 is the same as an extending direction of the first doped layers 12. The second fingers 22 are disposed on the second doped layers 13, and an extending direction of the second fingers 22 is the same as an extending direction of the second doped layers 13.

It should be noted that in this embodiment of the present application, the first direction X is a length direction of the substrate 11 or a width direction of the substrate 11. When the first direction X is the length direction of the substrate 11, the second direction Y is the width direction of the substrate 11. When the first direction X is the width direction of the substrate 11, the second direction Y is the length direction of the substrate 11.

As shown in FIG. 1 to FIG. 12, the first connecting members 50 extend along the second direction Y and are connected to the first fingers 20. The first connecting members 50 gather current collected by the first fingers 20 and transfer the collected current to an external circuit.

It should be noted that the first surface of the substrate 11 has the first region 14 and a second region 15. Along the second direction Y, the second region 15 and the first region 14 are disposed at an interval, and the second region 15 is closer to a side of the substrate 11 than the first region 14.

In the first region 14 of the first surface of the substrate 11, the intersections of the first connecting members 50 and the second fingers 22 are provided with the plurality of second insulating blocks 61 in a one-to-one correspondence with the second fingers 22, so that each second insulating block 61 blocks an electrical connection between the corresponding second finger 22 and the first connecting member 50, thereby avoiding the short-circuit in the solar cell string from affecting the photoelectric conversion efficiency of the solar cell string and improving a reliability of the solar cell string.

As shown in FIG. 1 to FIG. 12, along the second direction Y, at least a part of the second insulating blocks 61 extend into the first isolation regions 30 adjacent thereto. It can be understood that along the second direction Y, a part of the second insulating block 61 extends into the first isolation regions 30 adjacent thereto. In some embodiments, all of the second insulating blocks 61 extend into the first isolation regions 30 adjacent thereto.

In this embodiment of the present application, along the second direction Y, at least a part of the second insulating blocks 61 extend into the first isolation regions 30 adjacent thereto. In this way, after the second insulating blocks 61 are solidified, a reliability of a connection between the first connecting members 50 and the first fingers 20 is not affected, so as to avoid pseudo soldering in the solar cell string, thereby helping improve the photoelectric conversion efficiency of the solar cell string.

Further, the above disposition can also prevent a bonding material from overflowing to the first isolation regions 30 and from being connected to the second fingers 22 during soldering between the first connecting member 50 and the first finger 20, causing a short-circuit in the solar cell string, thereby helping improve the reliability of the solar cell string.

The first connecting member 50 in this embodiment of the present application is a soldering strip. For example, the first connecting member 50 is a square soldering strip, a circular soldering strip, a triangular soldering strip, or another polygonal soldering strip. Certainly, the first connecting member 50 is also another connecting member. In this embodiment of the present application, a specific type of the first connecting members 50 is not excessively limited. In an actual application, a person skilled in the art selects appropriate first connecting members 50 according to needs.

In some embodiments, as shown in FIG. 3 and FIG. 4, along the second direction Y, the second insulating block 61 does not extend to a boundary between the first doped layer 12 and the first isolation region 30 that are adjacent to the second insulating block.

As shown in FIG. 3 and FIG. 4, along the second direction Y, the second insulating block 61 does not extend to the boundary between the first doped layer 12 and the first isolation region 30 that are adjacent to the second insulating block. That is, along the second direction Y, the second insulating block 61 extends into the first isolation region 30 adjacent thereto, but does not extend to the boundary between the first isolation region 30 and the first doped layer 12 that are adjacent to the second insulating block.

The above disposition can avoid affecting the reliability of the connection between the first connecting member 50 and the first finger 20 after the second insulating blocks 61 are solidified, so as to avoid pseudo soldering in the solar cell string, thereby helping improve the reliability of the solar cell string and improving the photoelectric conversion efficiency of the solar cell string.

In some embodiments, as shown in FIG. 3 and FIG. 4, along the second direction Y, a width of the second insulating blocks 61 is W₁, a width of the second doped layers 13 is W₂, and a width of the first isolation regions 30 adjacent to the second doped layers 13 is W₃, where W₂<W₁≤W₂+2*W₃.

As shown in FIG. 3 and FIG. 4, in this embodiment of the present application, along the second direction Y, the width of the second insulating blocks 61 is set to W₁, the width of the second doped layers 13 is set to W₂, and the width of the first isolation regions 30 adjacent to the second doped layers 13 is set to W₃. The width W₁ of the second insulating blocks 61 is greater than the width W₂ of the second doped layers 13, and the width W₁ of the second insulating blocks 61 is less than or equal to a sum of the width W₂ of the second doped layers 13 and twice the width W₃ of the first isolation regions 30. In this way, the second insulating block 61 can cover a side edge of the second doped layer 13 close to the first isolation region 30, and the second insulating block 61 can be prevented from extending to the first doped layer 12 to cover the first finger 20, so that the first connecting member 50 cannot be electrically connected to the first finger 20.

In this embodiment of the present application, the width of the second insulating blocks 61 is set to be greater than the width of the second doped layers 13, so that the second insulating block 61 sufficiently covers the second doped layer 13, and the second insulating block 61 blocks the electrical connection between the second finger 22 and the first connecting member 50, thereby preventing the short-circuit in the solar cell string from affecting the photoelectric conversion efficiency of the solar cell string and improving the reliability of the solar cell string.

In this embodiment of the present application, the width of the second insulating blocks 61 is set to be less than or equal to the sum of the width of the second doped layers 13 and twice the width of the first isolation regions 30. In this way, the second insulating block 61 is prevented from extending to the adjacent first doped layer 12, and after the second insulating blocks 61 are solidified, the reliability of the connection between the first connecting member 50 and the first finger 20 is not affected, thereby avoiding pseudo soldering in the solar cell string and helping improve the photoelectric conversion efficiency of the solar cell string.

Further, the second insulating block 61 covers a side of the second doped layer 13. Even if the bonding material between the first doped layer 12 and the first connecting member 50 flows into the first isolation region 30, the second insulating block 61 can block the bonding material from being electrically connected to the second finger 22, thereby avoiding electric leakage in the solar cell string.

In some embodiments, as shown in FIG. 3 and FIG. 4, the solar cell string disclosed in this embodiment of the present application further includes a plurality of first bonding blocks 40. Each first bonding block 40 is disposed at a joint between one of the first fingers 20 and the first connecting member 50. Along a thickness direction of the solar cell 10, a height of the first bonding blocks 40 is greater than a height of the second insulating blocks 61.

As shown in FIG. 3 and FIG. 4, in this embodiment of the present application, the joint of each first finger 20 and the first connecting member 50 is provided with one first bonding block 40, so as to improve the reliability of the connection between the first finger 20 and the first connecting member 50 through the first bonding block 40, thereby preventing pseudo soldering between the first finger 20 and the first connecting member 50 from affecting the photoelectric conversion efficiency of the solar cell string.

In this embodiment of the present application, along the thickness direction of the solar cell 10, the height of the first bonding blocks 40 is set to be greater than the height of the second insulating blocks 61, so as to prevent the excessively high second insulating block 61 from pushing up the first connecting member 50, so that the first bonding block 40 adjacent to the second insulating block 61 cannot contact the first connecting member 50, affecting the reliability of the connection between the first bonding block 40 adjacent to the second insulating block 61 and the first connecting member 50, thus causing pseudo soldering in the solar cell string and affecting the photoelectric conversion efficiency of the solar cell string.

It should be noted that the first bonding block 40 is formed by printing a metal paste onto the joint of the first finger 20 and the first connecting member 50 by screen printing. For example, the first bonding block is formed by printing a tin paste onto the joint between the first finger 20 and the first connecting member 50 by screen printing. In some embodiments, the first bonding block is also formed by gathering a solderable coating (such as a solder layer) on the first connecting member 50 to a position to be soldered, for example, onto a thickened section.

In some embodiments, as shown in FIG. 3 and FIG. 4, the first finger 20 further includes a thickened section 21. Along the second direction Y, a width of the thickened section 21 is greater than a width of other parts of the first finger 20. The first bonding block 40 is disposed between the thickened section 21 and the first connecting member 50.

As shown in FIG. 3 and FIG. 4, the first finger 20 is provided with the thickened section 21. Along the second direction Y, the width of the thickened section 21 is greater than the width of other parts of the first finger 20. The first bonding block 40 is located between the thickened section 21 of the first finger 20 and the first connecting member 50. That is, the first finger 20 is connected to the first bonding block 40 and the first connecting member 50 by using the thickened section 21, thereby further improving the reliability of the connection between the first finger 20 and the first connecting member 50 and ensuring that the first finger 20 is connected to the first connecting member 50. The first connecting member 50 can transfer the current collected by the first fingers 20 to an external circuit, thereby improving the photoelectric conversion efficiency of the solar cell string, and preventing pseudo soldering between the first finger 20 and the first connecting member 50 from affecting the photoelectric conversion efficiency of the solar cell string.

It can be understood that the first finger 20 in this embodiment of the present application includes a first finger body and the thickened section 21 connected to the first finger body. The first finger body burns through a passivation layer on a surface of the substrate 11 and be connected to the substrate 11, so as to collect current generated by the substrate 11. However, the thickened section 21 cannot burn through the passivation layer on the surface of the substrate 11, and can only gather current collected by the first finger body and transfer the gathered current to the first connecting member 50. The thickened section 21 and the first finger body are integrally formed (for example, by printing) or are formed by two steps (for example, the thickened section 21 is printed before the first finger body is printed, and there is an overlap between the thickened section and the first finger body).

In some embodiments, as shown in FIG. 5 and FIG. 6, the solar cell string disclosed in this embodiment of the present application further includes second connecting members 51. The second connecting members 51 extend along the second direction Y. Along the first direction X, the second connecting members 51 and the first connecting members 50 are alternately disposed. The second connecting members 51 are connected to the second fingers 22. Intersections of the second connecting members 51 and the first fingers 20 are provided with a plurality of first insulating blocks 60 in a one-to-one correspondence with the first fingers 20. Along the second direction Y, at least a part of the first insulating blocks 60 extend into the first isolation regions 30 adjacent thereto.

As shown in FIG. 5 and FIG. 6, the solar cell string in this embodiment of the present application further includes the second connecting members 51. The second connecting members 51 extend along the second direction Y. Along the first direction X, the second connecting members and the first connecting members 50 are alternately disposed. The second connecting members 51 are connected to the second fingers 22. The first connecting members 50 are connected to the first fingers 20. When the first fingers 20 are positive electrode fingers, the second fingers 22 are negative electrode fingers. When the first fingers 20 are negative electrode fingers, the second fingers 22 are positive electrode fingers. By connecting the first connecting members 50 to the first fingers 20 and connecting the second connecting members 51 to the second fingers 22, positive electrode current and negative electrode current generated by the solar cell 10 are gathered and transferred respectively.

As shown in FIG. 5 to FIG. 6, in this embodiment of the present application, the intersections of the second connecting members 51 and the first fingers 20 are provided with the plurality of first insulating blocks 60 in a one-to-one correspondence with the first fingers 20, so that the first insulating blocks 60 block the first fingers 20 from the second connecting members 51, so as to prevent the first fingers 20 and the second connecting members 51 from electrical conduction, causing a short-circuit in the solar cell string and thus affecting the photoelectric conversion efficiency of the photovoltaic module.

It should be noted that as shown in FIG. 5 and FIG. 6, in this embodiment of the present application, along the second direction Y, at least a part of the first insulating blocks 60 extend into the first isolation regions 30 adjacent thereto. It can be understood that, along the second direction Y, a part of the first insulating blocks 60 extends into the first isolation regions 30 adjacent thereto. In some embodiments, alternatively, all of the first insulating blocks 60 extend into the first isolation regions 30 adjacent thereto.

In this embodiment of the present application, along the second direction Y, at least a part of the first insulating blocks 60 extend into the first isolation regions 30 adjacent thereto. In this way, after the first insulating blocks 60 are solidified, the reliability of the connection between the second connecting members 51 and the second fingers 22 is not affected, so as to avoid pseudo soldering in the solar cell string, thereby helping improve the photoelectric conversion efficiency of the solar cell string.

Further, the above disposition can also prevent the bonding material from overflowing to the first isolation regions 30 and from being connected to the first fingers 20 during soldering between the second connecting member 51 and the second finger 22, causing a short-circuit in the solar cell string, thereby helping improve the reliability of the solar cell string.

It should be noted that the second connecting member 51 in this embodiment of the present application is a soldering strip. For example, the second connecting member 51 is a square soldering strip, a circular soldering strip, a triangular soldering strip, or another polygonal soldering strip. Certainly, the second connecting member 51 is also another connecting member. In this embodiment of the present application, a specific type of the second connecting members 51 is not excessively limited. In an actual application, a person skilled in the art selects appropriate second connecting members 51 according to needs.

As shown in FIG. 5 to FIG. 6, in this embodiment of the present application, along the second direction Y, a width of the first doped layers 12 is equal to the width of the second doped layers 13.

As shown in FIG. 5 to FIG. 6, in this embodiment of the present application, along the second direction Y, the width of the first doped layers 12 is set to be equal to the width of the second doped layers 13, which facilitates preparation of the solar cell.

Certainly, the foregoing manner of setting the width of the first doped layers 12 to be equal to the width of the second doped layers 13 along the second direction Y is merely a specific implementation of this embodiment of the present application, and is not used as a limitation to the present application. In an actual application, a person skilled in the art sets the width of the first doped layers 12 and the width of the second doped layers 13 according to needs.

In some embodiments, as shown in FIG. 7 and FIG. 8, the solar cell string in this embodiment of the present application further includes second connecting members 51. The second connecting members 51 extend along the second direction Y. Along the first direction X, the second connecting members 51 and the first connecting members 50 are alternately disposed. The second connecting members 51 are connected to the second fingers 22. Intersections of the second connecting members 51 and the first fingers 20 are provided with a plurality of first insulating blocks 60 in a one-to-one correspondence with the first fingers 20. Along the second direction Y, a width of the first insulating blocks 60 is less than a width of the first doped layers 12 corresponding thereto. In a plane where the solar cell 10 is located, the first insulating block 60 has a second projection. The second projection falls into the corresponding first doped layer 12.

As shown in FIG. 7 and FIG. 8, the solar cell string in this embodiment of the present application further includes the second connecting members 51. The second connecting members 51 extend along the second direction Y. Along the first direction X, the second connecting members and the first connecting members 50 are alternately disposed. The second connecting members 51 are connected to the second fingers 22. The first connecting members 50 are connected to the first fingers 20. When the first fingers 20 are positive electrode fingers, the second fingers 22 are negative electrode fingers. When the first fingers 20 are negative electrode fingers, the second fingers 22 are positive electrode fingers. By connecting the first connecting members 50 to the first fingers 20 and connecting the second connecting members 51 to the second fingers 22, positive electrode current and negative electrode current generated by the solar cell 10 can be gathered and transferred.

As shown in FIG. 7 to FIG. 8, in this embodiment of the present application, the intersections of the second connecting members 51 and the first fingers 20 are provided with the plurality of first insulating blocks 60 in a one-to-one correspondence with the first fingers 20, so that the first insulating blocks 60 block the first fingers 20 from the second connecting members 51, so as to prevent the first fingers 20 and the second connecting members 51 from electrical conduction, causing a short-circuit in the solar cell string and thus affecting the photoelectric conversion efficiency of the photovoltaic module.

It should be noted that, as shown in FIG. 7 and FIG. 8, in this embodiment of the present application, along the second direction Y, the width of the first insulating blocks 60 is less than the width of the first doped layers 12 corresponding thereto. In the plane where the solar cell 10 is located, the first insulating block 60 has the second projection. The second projection falls into the corresponding first doped layer 12. With the above disposition, the first insulating block 60 can block the first finger 20 from the second connecting member 51, so as to prevent the first finger 20 and the second connecting member 51 from electrical conduction, causing a short-circuit in the solar cell string and thus affecting the photoelectric conversion efficiency of the solar cell string.

Further, with the above disposition, even after being solidified, the first insulating block 60 will not extend between the second connecting member 51 and the second finger 22 to affect the reliability of the connection between the second connecting member 51 and the second finger 22, thereby avoiding pseudo soldering in the solar cell string and helping improve the photoelectric conversion efficiency of the solar cell string.

In some embodiments, as shown in FIG. 7 and FIG. 8, along the second direction Y, the width of the first doped layers 12 is greater than the width of the second doped layers 13. A doping type of the second doped layers 13 is the same as a doping type of the substrate 11.

As shown in FIG. 7 and FIG. 8, in this embodiment of the present application, along the second direction Y, the width of the first doped layers 12 is set to be greater than the width of the second doped layers 13. The doping type of the second doped layers 13 is set to be the same as the doping type of the substrate 11, while the doping type of the first doped layers 12 is different from the doping type of the substrate 11. In this case, the first doped layer 12 can form a PN junction with the substrate 11. Setting the width of the first doped layers 12 to be greater than the width of the second doped layers 13 helps improve the photoelectric conversion efficiency of the solar cell string.

Further, because the first doped layers 12 are used to collect holes, a probability of electric leakage of a side of the first doped layer 12 is very small. In this embodiment of the present application, along the second direction Y, the width of the first insulating blocks 60 is set to be less than the width of the first doped layers 12 corresponding thereto. In the plane where the solar cell 10 is located, the first insulating block 60 has the second projection. The second projection is set to fall into the corresponding first doped layer 12. The above disposition does not cause electric leakage of the first doped layers 12, and can reduce a material usage of the first insulating blocks 60, thereby helping reduce production costs of the solar cell string. Certainly, because of printing precision, there is a small quantity of second projections of the first insulating blocks 60 on the solar cell 10 that are offset from a boundary of the first doped layer 12 on one side. In some embodiments, along the second direction Y, the width of the first insulating blocks 60 is approximately the same as the width of the second insulating blocks 61. Alternatively, in other embodiments, along the second direction Y, the width of the first insulating blocks 60 is greater than the width of the second insulating blocks 61. For example, a width of the insulating block covering a P-type finger is greater than a width of the insulating block covering an N-type finger.

In some embodiments, as shown in FIG. 9 to FIG. 12, in this embodiment of the present application, the first surface of the substrate 11 further includes a second region 15 adjacent to the first region 14 along the second direction Y. First connecting portions 70 are disposed on the second region 15. The first connecting portions 70 extend along the second direction Y. Along the second direction Y, the second region 15 is closer to an edge of the substrate 11 than the first region 14. The first connecting portion 70 is connected to a plurality of the first doped layers 12. Along the first direction X, a second isolation region 31 is provided between the second doped layer 13 and the first connecting portion 70. The second isolation region 31 is in communication with the first isolation region 30. The second doped layers 13 on two sides of the first connecting portion 70 are provided with the second fingers 22. An end of the second finger 22 close to the first connecting portion 70 is provided with the second insulating block 61. The second insulating block 61 extends into the first isolation regions 30 adjacent thereto and the second isolation regions 31 adjacent thereto.

As shown in FIG. 9 to FIG. 12, the first surface of the substrate 11 has the first region 14 and the second region 15. The first region 14 and the second region 15 are sequentially disposed along the second direction Y. The second region 15 is closer to the edge of the substrate 11 than the first region 14.

The second region 15 is provided with the first connecting portions 70. The first connecting portion 70 extends along the second direction Y and is connected to a plurality of the first doped layers 12. In this way, the first connecting portion 70 is connected to the first finger 20 located on the first doped layer 12, so that the first connecting portion 70 gathers current collected by the first fingers 20 and transfers the collected current to the first connecting member 50. The first connecting member 50 transfers the gathered current to an external circuit.

As shown in FIG. 9 to FIG. 12, along the first direction X, the second isolation region 31 is provided between the second doped layer 13 and the first connecting portion 70. The second isolation region 31 is in communication with the first isolation region 30. That is, along the second direction Y, the first isolation region 30 is provided between the first doped layer 12 and the adjacent second doped layer 13, so that the first isolation region 30 blocks the first doped layer 12 from the second doped layer 13, so as to prevent the first doped layer 12 and the second doped layer 13 from electrical conduction, causing a short-circuit in the solar cell and affecting the photoelectric conversion efficiency of the solar cell. Along the first direction X, the second isolation region 31 is provided between the second doped layer 13 and the adjacent first connecting portion 70, so that the second isolation region 31 blocks the second doped layer 13 from the adjacent first connecting portion 70, so as to prevent the second doped layer 13 and the adjacent first connecting portion 70 from electrical conduction, causing a short-circuit in the solar cell and affecting the photoelectric conversion efficiency of the solar cell.

As shown in FIG. 9 to FIG. 12, along the first direction X, the second doped layers 13 on two sides of the first connecting portion 70 are provided with the second fingers 22. The end of the second finger 22 close to the first connecting portion 70 is provided with the second insulating block 61. The second insulating block 61 extends into the first isolation regions 30 adjacent thereto and the second isolation regions 31 adjacent thereto. Thereby, the second insulating block 61 blocks the second finger 22 from the first connecting member 50 and the second finger 22 and the first connecting portion 70, so as to prevent the second finger 22 and the first connecting member 50 from electrical conduction or the second finger 22 and the first connecting portion 70 from electrical conduction, causing a short-circuit in the solar cell 10 and affecting the reliability of the solar cell 10, thereby affecting the photoelectric conversion efficiency of the solar cell string.

In some embodiments, as shown in FIG. 9 and FIG. 12, in this embodiment of the present application, the first connecting portion 70 is provided with an end line 71. The end line 71 extends along the second direction Y. The end line 71 is connected to the first fingers 20. Along the first direction X, a first distance d₁ is provided between an end portion of the second finger 22 close to the end line 71 and an end portion of the corresponding second insulating block 61 close to the end line 71, where 0.3 mm≤d₁≤1.5 mm.

As shown in FIG. 9 and FIG. 12, the first connecting portion 70 includes a first connecting portion body and the end line 71 connected to the first connecting portion body. The end line 71 extends along the second direction Y. Along the second direction Y, the end line 71 is closer to the edge of the substrate 11 than the first connecting portion body. The end line 71 is connected to the first finger 20, so that the end line 71 gathers current collected by the first fingers 20 and transfers the gathered current to an external circuit by using the first connecting member 50.

It should be noted that in this embodiment of the present application, along the first direction X, the first distance d₁ is provided between the end portion of the second finger 22 close to the end line 71 and the end portion of the corresponding second insulating block 61 close to the end line 71. The first distance is greater than or equal to 0.3 mm and less than or equal to 1.5 mm. For example, the first distance is 0.3 mm, 0.5 mm, 0.7 mm, 1.0 mm, 1.2 mm, or 1.5 mm.

In this embodiment of the present application, along the first direction X, the first distance between the end portion of the second finger 22 close to the end line 71 and the end portion of the corresponding second insulating block 61 close to the end line 71 is set to be greater than or equal to 0.3 mm and less than or equal to 1.5 mm, so that the second insulating block 61 can cover the end portion of the second finger 22 close to the end line 71, so as to prevent the end portion of the second finger 22 close to the end line 71 from being connected to the first connecting member 50, causing a short-circuit in the solar cell string and affecting the photoelectric conversion efficiency of the solar cell string.

It should be noted that in this embodiment of the present application, the end line 71 does not burn through the passivation layer on the surface of the substrate 11, that is, the end line 71 cannot collect the current generated by the substrate 11. The end line 71 is connected to the first fingers 20, and can gather the current collected by the first fingers 20 and transfer the gathered current to an external circuit through the first connecting member 50.

In addition, the first connecting members 50 extend along the second direction Y. The first connecting member 50 extends from a top of the second region 15 to a top of the first region 14. The first connecting member 50 covers a top of the end line 71 on the second region 15, and covers a top of the thickened section 21 on the first region 14, so that the first connecting member 50 can gather the current collected by the end line 71 and the thickened section 21 and transfer the current to an external circuit.

In some embodiments, as shown in FIG. 9 to FIG. 12, in this embodiment of the present application, a second distance d₂ is provided between the second finger 22 and the first doped layer 12 or the first connecting portion 70, where 0.1 mm≤d₂≤0.5 mm and/or d₁>d₂.

As shown in FIG. 9 to FIG. 12, in this embodiment of the present application, the second distance is provided between the second finger 22 and the first doped layer 12 or the first connecting portion 70. The second distance is greater than or equal to 0.1 mm and less than or equal to 0.5 mm, to prevent the second finger 22 and the first doped layer 12 or the first connecting portion 70 from electrical conduction, causing a short-circuit in the solar cell string, thereby improving the reliability of the solar cell string and improving the photoelectric conversion efficiency of the solar cell string.

For example, the second distance between the second finger 22 and the first doped layer 12 or the first connecting portion 70 is set to 0.1 mm, 0.2 mm, 0.3 mm, 0.4 mm, 0.5 mm, or the like.

It should be noted that in this embodiment of the present application, the second distance d₂ between the second finger 22 and the first doped layer 12 or the first connecting portion 70 is also set to be greater than the first distance d₁ between the end portion of the second finger 22 close to the end line 71 and the end portion of the corresponding second insulating block 61 close to the end line 71, so that the second insulating block 61 can at least partially extend into the first isolation region 30 or the second isolation region 31. In this way, after the second insulating blocks 61 are solidified, the reliability of the connection between the first connecting members 50 and the first fingers 20 is not affected, so as to avoid pseudo soldering in the solar cell string, thereby helping improve the photoelectric conversion efficiency of the solar cell string.

Further, the above disposition can also prevent the bonding material from overflowing to the first isolation regions 30 and from being connected to the second fingers 22 during soldering between the first connecting member 50 and the first finger 20, causing a short-circuit in the solar cell string, thereby helping improve the reliability of the solar cell string.

In addition, the second insulating block 61 covers the side of the second doped layer 13. Even if the bonding material between the first doped layer 12 and the first connecting member 50 flows into the first isolation region 30, the second insulating block 61 can block the bonding material from being electrically connected to the second finger 22, thereby avoiding electric leakage in the solar cell string.

In some embodiments, as shown in FIG. 9 to FIG. 12, in this embodiment of the present application, the second insulating block 61 extends to the first connecting portion 70 and/or the first doped layer 12.

As shown in FIG. 9 to FIG. 12, in this embodiment of the present application, the second insulating block 61 extends to the first connecting portion 70 and/or the first doped layer 12, so that the second insulating block 61 can completely fill up the first isolation region 30 and/or the second isolation region 31, thereby ensuring that the second finger 22 is blocked from the first connecting member 50, avoiding a short-circuit in the solar cell string, and improving the photoelectric conversion efficiency of the solar cell string.

Further, the above disposition can also prevent the bonding material between the first connecting member 50 and the first finger 20 from overlapping with the second finger 22, causing an electrical conduction between the first finger 20 and the second finger 22, thus causing a short-circuit in the solar cell string and affecting the photoelectric conversion efficiency of the solar cell string.

In some embodiments, as shown in FIG. 11 and FIG. 12, in this embodiment of the present application, the second insulating block 61 covers an end of the second finger 22 on one side of the first connecting portion 70, and extends through the first connecting portion 70, and covers an end of the second finger 22 on an other side of the first connecting portion 70.

As shown in FIG. 11 and FIG. 12, in this embodiment of the present application, the second insulating blocks 61 are strip-shaped and extend along the second direction Y. One end of the second insulating block 61 covers the end of the second finger 22 on one side of the first connecting portion 70. The second insulating block 61 extends and passes through the first connecting portion 70, and covers the end of the second finger 22 on the other side of the first connecting portion 70. In this way, one second insulating block 61 can cover the ends of two second fingers 22 located on the two sides of the first connecting portion 70, so as to facilitate preparation of the solar cell string, simplify a preparation process of the solar cell string, and reduce preparation costs of the solar cell string.

It should be noted that in this embodiment of the present application, the first doped layers 12 and the second doped layers 13 are all made of a polycrystalline silicon material. The solar cell is a TBC solar cell. A tunneling oxide layer (not shown in the figure) is further provided between the first doped layer 12 and the second doped layer 13 and the substrate 11. The first isolation region 30 is a part without a doped layer between the first doped layer 12 and the second doped layer 13. The edge of the first isolation region 30 is defined by the first doped layer 12 and the second doped layer 13, so it is more necessary for the insulating block to electrically isolate the first isolation region 30. In addition, a passivation insulating layer is further provided between the first doped layer 12 and the first finger 20, and between the second doped layer 13 and the second finger 22. The first finger 20 and the second finger 22 at least partially burn through the passivation insulating layer and are electrically connected to the first doped layer 12 and the second doped layer 13. The passivation insulating layer covers the first isolation region 30. Further, the insulating block covers at least a part of the passivation insulating layer in the first isolation region 30.

Certainly, the foregoing disposition for the first doped layers 12 and the second doped layers 13 is merely an individual embodiment of the embodiments of the present application, and is not used as a limitation to the present application. In an actual application, a person skilled in the art sets specific types of the first doped layers 12 and the second doped layers 13 according to needs.

An embodiment of the present application further discloses a photovoltaic module. The photovoltaic module includes the solar cell string according to the foregoing embodiment.

It should be noted that a structure of the solar cell string included in the photovoltaic module in this embodiment of the present application is the same as that of the solar cell string in the foregoing embodiment, and beneficial effects thereof are also similar. Details are not described herein again.

The foregoing described apparatus embodiments are merely examples. The units described as separate parts can or cannot be physically separate, and the parts displayed as units can or cannot be physical units, can be located in one position, or can be distributed on a plurality of network units. Some or all of the modules are selected according to actual needs to achieve the objectives of the solutions of the embodiments. Persons of ordinary skill in the art can perform understanding and implementation without creative efforts.

"One embodiment", "Embodiment", or "one or more embodiments" mentioned in this specification mean that particular features, structures, or characteristics described with reference to the embodiments are included in at least one embodiment of the present application. In addition, it should be noted that the phrase example of "in an embodiment" does not necessarily refer to a same embodiment.

In the specification provided herein, a large number of specific details are described. However, it can be understood that, the embodiments of the present application can be practiced without these specific details. In some embodiments, well-known methods, structures, and technologies are not shown in detail, so as not to obscure understanding of this specification.

In the claims, any reference signs between brackets should not be constructed as a limitation to the claims. The word "including" does not exclude elements or steps that are not listed in a claim. The word "one" or "a" before an element does not exclude a plurality of such elements. The present application is implemented by using hardware including several different elements, and by using a properly programmed computer. In a unit claim enumerating several apparatuses, several of these apparatuses are specifically embodied by a same hardware item. The use of the words first, second, and third does not indicate any order. These words are explained as names.

Finally, it should be noted that, the foregoing embodiments are merely intended for describing the technical solutions of the present application, but not for limiting the present application. Although the present application is described in detail with reference to the foregoing embodiments, a person of ordinary skill in the art is to understand that modifications can still be made to the technical solutions described in the foregoing embodiments or equivalent replacements can be made to some technical features thereof, provided that such modifications or replacements do not cause the essence of corresponding technical solutions to depart from the spirit and scope of the technical solutions of the embodiments of the present application.

## Claims

1. A solar cell string, comprising:
a solar cell, the solar cell comprising a substrate and a plurality of first doped layers and a plurality of second doped layers formed on a first surface of the substrate, the first doped layers and the second doped layers all extending along a first direction and being alternately arranged along a second direction, a first isolation region being provided between the first doped layer and the adjacent second doped layer, first fingers being disposed on the first doped layers, second fingers being disposed on the second doped layers, the first fingers and the second fingers all extending along the first direction, and the second direction intersecting with the first direction; and
first connecting members, the first connecting members extending along the second direction, the first connecting members being connected to the first fingers, and in a first region of the first surface, intersections of the first connecting members and the second fingers being provided with a plurality of second insulating blocks in a one-to-one correspondence with the second fingers; and along the second direction, at least a part of the second insulating blocks extending into the first isolation regions adjacent thereto.

2. The solar cell string according to claim 1, wherein along the second direction, the second insulating block does not extend to a boundary between the first doped layer and the first isolation region that are adjacent to the second insulating block.

3. The solar cell string according to claim 1, wherein along the second direction, a width of the second insulating blocks is W₁, a width of the second doped layers is W₂, and a width of the first isolation regions adjacent to the second doped layers is W₃, wherein W₂<W₁≤W₂+2*W₃.

4. The solar cell string according to any one of claims 1 to 3, wherein the solar cell string further comprises a plurality of first bonding blocks,
the first bonding block being disposed at a joint between one of the first fingers and the first connecting member; and
along a thickness direction of the solar cell, a height of the first bonding blocks is greater than a height of the second insulating blocks.

5. The solar cell string according to claim 4, wherein the first finger comprises a thickened section, along the second direction, a width of the thickened section being greater than a width of other parts of the first finger, and
the first bonding block being disposed between the thickened section and the first connecting member.

6. The solar cell string according to claim 1, wherein the solar cell string further comprises:
second connecting members, the second connecting members extending along the second direction, along the first direction, the second connecting members and the first connecting members being alternately disposed, and the second connecting members being connected to the second fingers, wherein
intersections of the second connecting members and the first fingers are provided with a plurality of first insulating blocks in a one-to-one correspondence with the first fingers; and along the second direction, at least a part of the first insulating blocks extend into the first isolation regions adjacent thereto.

7. The solar cell string according to claim 6, wherein along the second direction, a width of the first doped layers is equal to a width of the second doped layers.

8. The solar cell string according to claim 1, wherein the solar cell string further comprises:
second connecting members, the second connecting members extending along the second direction, along the first direction, the second connecting members and the first connecting members being alternately disposed, and the second connecting members being connected to the second fingers, wherein
intersections of the second connecting members and the first fingers are provided with a plurality of first insulating blocks in a one-to-one correspondence with the first fingers, along the second direction, a width of the first insulating blocks being less than a width of the first doped layers corresponding thereto; and
in a plane where the solar cell is located, the first insulating block has a second projection, the second projection falling into the corresponding first doped layer.

9. The solar cell string according to claim 8, wherein along the second direction, the width of the first doped layers is greater than a width of the second doped layers, and a doping type of the second doped layers is the same as a doping type of the substrate.

10. The solar cell string according to claim 1, wherein the first surface further comprises a second region adjacent to the first region along the second direction, and first connecting portions are disposed on the second region, the first connecting portions extending along the second direction; and along the second direction, the second region is closer to an edge of the substrate than the first region;
the first connecting portion is connected to the plurality of the first doped layers, and along the first direction, and a second isolation region is provided between the second doped layer and the first connecting portion, the second isolation region being in communication with the first isolation region; and
the second doped layers on two sides of the first connecting portion are provided with the second fingers; and an end of the second finger close to the first connecting portion is provided with the second insulating block, the second insulating block extending into the first isolation regions adjacent thereto and the second isolation regions adjacent thereto.

11. The solar cell string according to claim 10, wherein the first connecting portion is provided with an end line, the end line extending along the second direction, and the end line being connected to the first fingers; and
along the first direction, a first distance d₁ is provided between an end portion of the second finger close to the end line and an end portion of the corresponding second insulating block close to the end line, wherein 0.3 mm≤d₁≤1.5 mm.

12. The solar cell string according to claim 11, wherein a second distance d₂ is provided between the second finger and the first doped layer or the end line, wherein 0.1 mm≤d₂≤0.5 mm.

13. The solar cell string according to claim 12, wherein d₁>d₂.

14. The solar cell string according to claim 10, wherein the second insulating block extends to the first connecting portion.

15. The solar cell string according to claim 10, wherein the second insulating block extends to the first doped layer.

16. The solar cell string according to claim 10, wherein the second insulating block covers an end of the second finger on one side of the first connecting portion, and extends through the first connecting portion, and covers an end of the second finger on an other side of the first connecting portion.

17. A photovoltaic module, comprising the solar cell string according to any one of claims 1 to 16.
